# EUROPÄISCHE PATENTSCHRIFT

(11) **EP 1 378 936 B1**
(45) Veröffentlichungstag und Bekanntmachung des Hinweises auf die Patenterteilung: **19.01.2011**
(21) Anmeldenummer: 03013693.1
(22) Anmeldetag: 17.06.2003
(51) Int. Cl.: H01L 21/68, H01L 21/00

(54) **Elektrostatisches Halteelement**
Electrostatic chuck
Mandrin électrostatique

(30) Priorität: 01.07.2002 DE 10230660; 27.08.2002 DE 10240356
(43) Veröffentlichungstag der Anmeldung: 07.01.2004
(73) Patentinhaber: Fraunhofer-Gesellschaft zur Förderung der angewandten Forschung e.V., 80686 München (DE)
(72) Erfinder: Kalkowski, Gerhard, Dr. rer. nat., 07743 Jena (DE); Risse, Stefan, Dipl.-Ing., 07749 Jena (DE)
(74) Vertreter: Pfenning, Meinig & Partner GbR

(56) Entgegenhaltungen:
- US-A- 5 777 838
- US-A- 5 886 863
- PATENT ABSTRACTS OF JAPAN Bd. 2000, Nr. 14, 5. März 2001 (2001-03-05) & JP 2000 323558 A (NIKON CORP), 24. November 2000 (2000-11-24)

## Beschreibung

Die Erfindung betrifft elektrostatische Halteelemente, die für die Herstellung von Elementen, die bei der lithographischen Strukturierung von Halbleiterelementen sowie Substrate für Halbleiterelemente, die bei der Herstellung lithographisch strukturiert werden, einsetzbar sind. Der Einsatz der erfindungsgemäßen Halteelemente bietet sich insbesondere dann an, wenn für die lithographische Strukturierung kurzwellige elektromagnetische Strahlung, wie beispielsweise der Strahlung im Wellenlängenbereich des extremen ultravioletten Lichtes, also mit Wellenlängen < 100 nm, eingesetzt werden soll.

Da die Strahlung für sehr feine Strukturierungen genutzt wird und in diesem Wellenlängenbereich eine relativ kleine optische Tiefenschärfe vorliegt, sind die Anforderungen an die Positioniergenauigkeit der jeweiligen Elemente oder Substrate sehr hoch, wobei es sich im erstgenannten Fall in der Regel um die so genannten Masken und bei den Substraten in der Regel um die so genannten Wafer handelt.

Da die kurzwellige Strahlung von Gasen absorbiert wird und daher die Herstellung der Strukturen in der Regel innerhalb von Vakuumkammern durchgeführt wird, scheiden Halteelemente, deren Haltekräfte durch Erzeugung von Unterdruck aufgebracht werden, eigentlich aus.

In der jüngsten Vergangenheit haben sich daher Lösungen herauskristallisiert, bei denen das Halten der scheibenförmigen Elemente oder Substrate elektrostatisch bewirkt wird. Dazu muss das Element oder Substrat eine endliche elektrische Leitfähigkeit besitzen, wobei erfahrungsgemäß die intrinsische Leitfähigkeit von Halbleitern wie Silizium, Germanium oder Gallium-Arsenid völlig ausreicht, wenigstens aber ein um 3 Größenordnungen geringerer spezifischer elektrischer Widerstand des Elements oder Substrats gegenüber jenem des Halteelementes vorliegen muss. Ist dies nicht der Fall (z.B. bei Glas), so kann durch Aufbringen (Aufdampfen, Sputtern) einer hinreichend dicken Metallschicht (erfahrungsgemäß d > 20 nm) auf der dem Halteelement zugewandten Seite eine ausreichende Haltekraft erreicht werden.

Bei den bekannten Lösungen wird zwischen einer Elektrode und dem jeweils zu fixierenden Element oder Substrat ein elektrischer Isolator als Halteelement angeordnet und mit einer elektrischen Gleich- oder Wechselspannung mittels Coulomb-Kräften eine Kraftwirkung zur Fixierung des jeweiligen Elementes oder Substrates bewirkt. Sofern es sich bei dem Halteelementwerkstoff einen relativ "schlechten" Isolator mit nicht unendlich großem spezifischen elektrischen Widerstand handelt (in praxi sind bisher 10¹⁰-10¹³ Ohm cm in Gebrauch, so wird eine weitere attraktive Kraft, die so genannte Johnson-Rahbek-Kraft beobachtet.

Für die elektrostatischen Halteeinrichtungen sind einpolare, bipolare oder auch multipolare Lösungen bekannt. Dabei werden bei einer einpolaren Lösung eine Elektrode eingesetzt und der eine Pol einer Gleichspannungsquelle an diese Elektrode und der andere Pol der Gleichspannungsquelle an das jeweilige Element oder das jeweilige Substrat angeschlossen.

Bei einer bipolaren Lösung werden zwei in einem Abstand zueinander angeordnete Elektroden an die beiden unterschiedlichen Pole einer Gleichspannungsquelle angeschlossen und die beiden Elektroden sind auf der einen Seite des elektrisch isolierenden Halteelementes und das jeweilige Element oder Substrat auf der jeweils anderen Seite dieses Halteelementes angeordnet. Dabei kann das erfindungsgemäße Halteelement sowohl bei einpolaren, wie auch bipolaren Lösungen eingesetzt werden.

Ein bekanntes Beispiel für solche elektrisch isolierenden Halteelemente ist in US 5,777,838 beschrieben. Dabei soll ein kleinerer Wärmeausdehungskoeffizient und ein spezifischer Widerstand im Bereich von 10¹³ Ωcm bei einer kleinen Dicke eines Halteelements erreicht sein.

Es sind an einer Oberfläche des dort beschriebenen Halteelementes Erhebungen ausgebildet, an deren Oberflächen das jeweils zu fixierende Element oder Substrat aufliegt, so dass infolge der verkleinerten Be rührungsflächen zwischen Halteelement und dem zu fixierenden Element oder Substrat eine erhöhte Haltekraft erreichbar ist und zum anderen durch die zwischen den Erhebungen ausgebildeten Hohlräume Helium zur Kühlung des gehaltenen Elementes geführt werden kann.

Wegen der bereits eingangs erwähnten weiter erhöhten Positioniergenauigkeitsanforderungen würde sich aber eine solche Gaszufuhr nachteilig auswirken, da gegebenenfalls Partikel eindringen können, da inhomogene Temperaturverteilungen auftreten können und im Rahmen der thermischen Ausdehnung geometrische Verzerrungen von z.B. Wafer/Maske bewirken können. Außerdem ist ein erheblicher Aufwand nötig, um eine derartige Kühlung zu gewährleisten und es schränkt die Verwendbarkeit ein. Z.B. kann ein bewegliches Halteelement nur schwer mit einer Kühlleitung versehen werden.

Des Weiteren kann mit einer solchen Gaskühlung nicht gewährleistet werden, dass eine gleichmäßige Temperatur an allen Positionen eines solchen Halteelementes eingehalten wird und dadurch ebenfalls Lageabweichungen des jeweiligen Elementes oder Substrates auftreten können.

Es ist daher Aufgabe der Erfindung elektrostatische Halteelemente zur Verfügung zu stellen, die im Vakuum eingesetzt werden können und mit denen eine fixierte Positionierung von Elementen oder Substraten mit erhöhter Positioniergenauigkeit und ausreichend hoher Haltekraft erreichbar sind.

Erfindungsgemäß wird diese Aufgabe mit elektrostatischen Halteelementen, die die Merkmale des Anspruchs 1 aufweisen, gelöst.

Vorteilhafte Ausgestaltungsformen und Weiterbildungen der Erfindung können mit den in den untergeordneten Ansprüchen genannten Merkmalen erreicht werden.

Für die erfindungsgemäßen elektrostatischen Halteelemente wird ein Werkstoff eingesetzt, dessen spezifischer elektrischer Widerstand bei einer Raumtemperatur von 20 °C oberhalb 10¹³ Ωcm liegt. Er weist einen Wärmeausdehnungskoeffizienten auf, dessen absoluter Betrag < 10⁻⁷/K, zumindest in einem Temperaturbereich zwischen 0 °C und 50 °C liegt.

Die Dicke des erfindungsgemäßen Halteelementes ist dabei kleiner als 0,5 mm, was zumindest auf den dielektrischen Teil zutrifft.

Dabei können infolge der relativ hohen elektrischen Haltekräfte besondere Einebnungseffekte am Element bzw. Substrat erzielt werden und dadurch die Belichtungsergebnisse bei geringer Schärfentiefe deutlich verbessert werden.

Insbesondere die äußerst kleine Wärmeausdehnung wirkt sich auf die Positioniergenauigkeit vorteilhaft aus.

Der erfindungsgemäß zu verwendende Werkstoff weist dabei innerhalb seines Gefüges mikroskopisch kleine Bereiche mit negativem Wärmeausdehnungsverhalten zumindest innerhalb eines Temperaturinterwalles auf.

Erfindungswesentlich ist der Werkstoff als Dielektrikum für das Halteelement mit einem Alkali/Erdalkali-Alumino-Silikat-System in einer SiO-Matrix gebildet. Bevorzugt ist ein hoher SiO₂-Gehalt (> 50 Masse-%).

Besonders geeignete Zusätze sind beispielsweise LiAlSiO₄, LiAlSi₂O₆ bzw. Zn_{0,5} AlSi₂O₃, die zu Ausscheidungen im Werkstoffgefüge mit Bereichen führen, die eine negative thermische Ausdehnung aufweisen und die positive thermische Ausdehnung von umgebenden SiO₂-Phasen zu nahezu "Null" kompensieren.

Entsprechend sollte der Werkstoff eine so genannte "High-Quarz" Struktur aufweisen, wie dies beispielsweise von H. Bach in "Low Thermal Expansion Glass Ceramics"; Springer Verlag; 1999, Seiten 13 bis 24 beschrieben ist, eingesetzt werden.

Insbesondere durch diese günstigen thermischen Eigenschaften ist es möglich, während des Einsatzes der erfindungsgemäßen elektrostatischen Halteelemente auf eine Kühlung zu verzichten oder eine reduzierte Kühlung verwenden zu können und somit deren Nachteile und den damit verbundenen zusätzlichen Aufwand weitgehend zu vermeiden und trotzdem eine hohe Positioniergenauigkeit der zu fixierenden Elemente oder Substrate zu erreichen.

Durch den erhöhten spezifischen elektrischen Widerstand kann mit entsprechend erhöhten elektrischen Spannungen gearbeitet werden und dadurch erhöhte Haltekräfte erreicht werden.

Im einfachsten Fall kann ein erfindungsgemäßes elektrostatisches Halteelement ein plattenförmiges Gebilde mit quadratischer, rechteckiger oder kreisförmiger Außenkontur sein.

Dabei sollte die gesamte Berührungsfläche oder mehrere diskret angeordnete Berührungsflächen, wobei auf Beispiele für solche Ausbildungsformen noch zurückzukommen sein wird, sehr eben sein, so dass Abweichungen nicht größer als 1 µm sein sollten.

Aufgrund des elektrischen Verhaltens des oben beschriebenen Werkstoffes kann davon ausgegangen werden, dass die Haltekräfte zum allergrößten Teil durch den so genannten "Johnson-Rahbek-Effekt" aufgebracht werden, der zu Haltekräften/Anziehungskräften unmittelbar an den Stellen der mechanischen Berührung von Element oder Substrat (Wafer/Maske) und Halteelement (Auflagefläche) führt.

Die ebenfalls vorhandenen - auf der gesamten Fläche auch über Vertiefungen wirkenden - Coulombkräfte sind demgegenüber vernachlässigbar gering. Somit liegen bei strukturierten Oberflächen mit Vertiefungen im Dielektrikum näherungsweise "keine" Anziehungskräfte auf das zu haltende Objekt unmittelbar über den Vertiefungen vor und es kommt entsprechend auch nicht zu einer Durchbiegung von Element oder Substrat (Wafer/Maske) in diesem Bereich.

Die Oberfläche für das Halten des jeweiligen Elementes oder Substrates ist strukturiert, so dass sich die gesamte Berührungsfläche gegenüber der Gesamtfläche eines Halteelementes entsprechend verringert.

Dies dient z.B. auch dazu, Partikel aufzunehmen und bei Partikeln kontaminierten Elementen/Substraten die Auflageebenheit zu erhöhen.

So besteht die Möglichkeit die Strukturierung in Form von Erhebungen auszubilden, die wiederum durch entsprechende Vertiefungen zwischen den Erhebungen voneinander getrennt sind. Die Erhebungen sollten abgeflachte Berührungsflächen aufweisen und alle Berührungsflächen in einer gemeinsamen Ebene angeordnet sein, wobei die Abweichungen der Anordnungen der Berührungsflächen von der gemeinsamen Ebene < 0,5 µm sein sollen.

Die Erhebungen können zylinderförmig, quaderförmig, als Kegel- oder auch Pyramidenstümpfe ausgebildet sein. Die Tiefe der zwischen den Erhebungen vorhandenen Vertiefungen sollte < 0,5 mm und > 0,001 mm sein.

Die Strukturierung an der entsprechenden Oberfläche des erfindungsgemäßen Halteelementes kann aber auch durch die Ausbildung von Vertiefungen in Form von kleinen Kratern oder auch Sacklöchern bzw. auch als Durchbrechungen ausgebildet sein. Dabei können Halteelemente mit Durchbrechungen ähnlich wie ein Gitternetzwerk eine Mehrlochblende oder auch ein Sieb ausgebildet sein.

Für die Einhaltung der gewünschten Positioniergenauigkeit der zu fixierenden Elemente oder Substrate sollte die eine oder bei strukturierter Oberfläche alle Berühungsflächen eine mittlere Rauhtiefe Ra und/oder quadratischen Mittelrauhwert R_{q} < 1 µm, bevorzugt < 0,5 µm aufweisen.

Vorteilhaft kann es sein, dass die Strukturierung über die gesamte Fläche des Halteelements gleichmäßig ausgebildet worden ist. Hierfür können die Erhebungen, Vertiefungen oder Durchbrechungen jeweils gleich dimensioniert und äquidistant angeordnet sein. Dabei ist unter gleicher Dimensionierung insbesondere die gleichmäßige Größe der Berührungsfläche und auch deren Gestalt zu verstehen.

Das Verhältnis der Summe der Berührungsflächen in Bezug zur Gesamtfläche des Halteelementes kann zwischen 1 : 1,01 und 1 : 200 liegen, wobei ein Verhältnis von 1 : 4 zu bevorzugen ist.

Es besteht aber auch die Möglichkeit die Strukturierung so auszubilden, dass die Summe der Berührungsflächen innerhalb eines äußeren Randbereiches des Halteelementes mindestens zweimal so groß, wie in einem zentralen Innenbereich des Halteelementes ist. Dabei sollte dieser Randbereich umlaufend um das Halteelement verstanden werden. Die Breite dieses äußeren Randbereiches sollte < als ein 1/4 der Diagonale oder des Durchmessers eines Halteelementes sein.

Auf der der strukturierten Oberfläche gegenüberliegenden Seite des Halteelementes ist mindestens eine Elektrode für den Anschluss einer elektrischen Spannung vorhanden.

Eine Weiterbildungsmöglichkeit für ein erfindungsgemäßes Halteelement besteht darin, zumindest eine Durchbrechung innerhalb eines zentralen Innenbereiches auszubilden. Mit Hilfe einer solchen Durchbrechung kann beispielsweise eine Ent- oder auch Belüftung erreicht werden, wobei eine Belüftung beispielsweise das Lösen des vorab fixierten Elementes oder Substrates erleichtern kann.

Mit Hilfe der Durchbrechung kann aber auch eine Unterdruck-Haltefunktion realisiert werden, so dass eine zweite Funktionalität bei Bedingungen gegeben ist, bei denen kein Vakuum erforderlich ist. So kann an eine oder auch mehrere solcher Durchbrechungen eine Unterdruck erzeugende Einheit (z.B. eine Vakuumpumpe) angeschlossen sein oder temporär angeschlossen werden. Mit Hilfe des Unterdruckes kann eine Haltekraftwirkung für zu fixierende Elemente bereits vorab und/oder eine die elektrostatisch erzeugte Kraft unterstützende zusätzliche Haltekraft ausgeübt werden. Letzteres wirkt sich vorteilhaft aus, da für die volle elektrostatisch erreichbare Haltekraftwirkung ein bestimmter Zeitraum erforderlich ist.

Die mindestens eine Durchbrechung oder ein zusätzlicher Freiraum können ein Unterdruckreservoir bilden, an die eine einen Unterdruck erzeugende Einrichtung angeschlossen und mittels eines Ventils verschlossen werden kann.

Außerdem können über eine oder mehrere solcher Durchbrechungen auch gegebenenfalls Partikel abgesaugt und eine Reinigung erreicht werden.

Die erfindungsgemäßen elektrostatischen Halteelemente können günstigerweise auch mindestens zwei reflektierende Flächen aufweisen. Diese reflektierenden Flächen sind unmittelbar am Halteelement ausgebildet und sowohl orthogonal zueinander, wie auch orthogonal in Bezug zur Ebene der Berührungsfläche(n) ausgerichtet. Mit Hilfe dieser mindestens zwei reflektierenden Flächen kann eine interferometrische Positionsbestimmung des Halteelementes erfolgen. Die Ebenheit der reflektierenden Flächen sollte hierzu in einem für die interferometrische Positionsbestimmung ausreichend großen Bereich mindestens 0,05 µm betragen. Die mittlere Rauhtiefe Ra und/oder die geometrische Rauheit R_{q} der reflektierenden Flächen sollte möglichst < 0,05 µm sein.

Die erfindungsgemäßen elektrostatischen Halteelemente können bei einer Dicke von 0,2 mm ohne weiteres beim Betrieb mit elektrischer Gleichspannung bis zu 500 V und unter bestimmten Umständen auch darüber hinaus betrieben werden, wobei sich grundsätzlich die anlegbare Spannung nach der Dicke des Halteelementes richtet und mit dünnerem Halteelement auch die Spannung verringert werden muss um Durchschläge zu vermeiden.

Da sich die elektrostatische Haltekraftwirkung bei dem angegebenen Werkstoff mit einer gewissen zeitlichen Verzögerung zur vollen Stärke entwickelt und nachfolgend wieder abgebaut wird, ist insbesondere der Einsatz für die Herstellung und/oder die Halterung von Masken, die für die photolithographische Strukturierung von Halbleiterelementen eingesetzt werden können, günstig, da es hierbei auf sehr kurze Haltezeiten nicht unbedingt ankommt.

Die Herstellung der erfindungsgemäßen elektrostatischen Halteelemente kann mit an sich bekannten Verfahren, wie sie für die Herstellung optischer Elemente eingesetzt werden, erfolgen. So kann die Bearbeitung durch Schleifen, Läppen, Polieren und gegebenenfalls auch durch das in jüngster Zeit eingeführte Ionenstrahlpolieren oder eine lokale mechanische Korrektur durch Polieren durchgeführt wird. Die Strukturierung kann beispielsweise ebenfalls photolithographisch erfolgen. Für die Ausbildung von Strukturierungen nach der Entwicklung können sowohl Nassätzverfahren wie Trockenätzverfahren eingesetzt werden.

Nachfolgend soll die Erfindung beispielhaft beschrieben werden.

Dabei zeigen:
- Figur 1: eine perspektivische Darstellung eines Beispiels eines erfindungsgemäßen elektrostatischen Halteelementes mit einer Oberflächenstrukturierung in Form von quaderförmigen Erhöhungen und
- Figur 2: eine perspektivische Darstellung eines Beispiels für ein elektrostatisches Halteelement mit einer Strukturierung in Form zylinderförmiger Erhebungen.

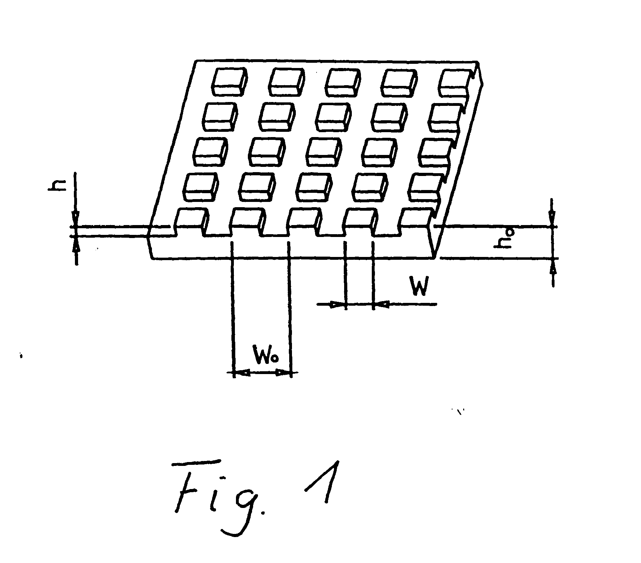

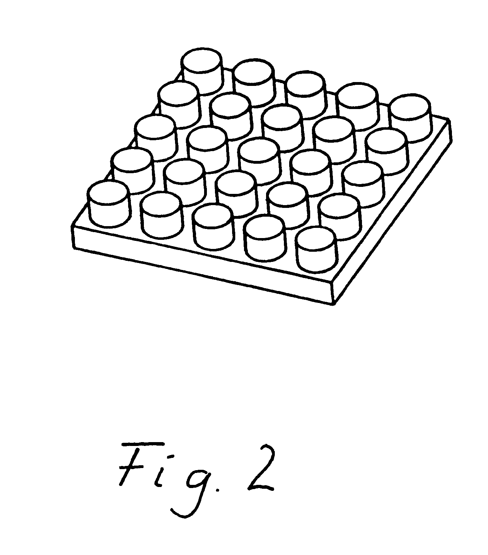

Für die Herstellung der in den Figuren 1 und 2 gezeigten Beispiele für erfindungsgemäße elektrostatische Halteelemente wurde ein Alkali-Erdalkali-Alumino-Silikat in einer SiO₂-Matrix eingesetzt, dessen spezifischer elektrischer Widerstand bei einer Raumtemperatur von 20 °C bei ca. 2,5 × 10¹³ Ωcm liegt.

Der Wärmeausdehnungskoeffizient dieses für die Herstellung eingesetzten Werkstoffes hatte einen absoluten Betrag von ≤ 0,1 × 10⁻⁶/K zumindest im Temperaturbereich zwischen 0 °C und 50 °C.

Bei dem in Figur 1 gezeigten Beispiel eines erfindungsgemäßen elektrostatischen Halteelementes wurde die Oberfläche, die für die Fixierung des jeweiligen Elementes oder Substrates eingesetzt wird, mit einer Strukturierung versehen, wobei dabei quaderförmige Erhebungen ausgebildet worden sind. Dabei wurde die Summe aller Berührungsflächen auf 1/4 der Gesamtfläche des Halteelementes reduziert.

Die Gesamtdicke h₀ betrug bei diesem Beispiel 0,2 mm. Die Tiefe der zwischen den Erhebungen ausgebildeten Vertiefungen h betrug bei diesem Beispiel 0,05 mm und die Verhältnisse w : w₀ hatte ein Verhältnis 1 : 2.

Bei dem in Figur 2 gezeigten Beispiel wurde die Strukturierung in Form zylinderförmigen Erhebungen ausgebildet, wobei diese Erhebungen, wie auch beim Beispiel nach Figur 1 jeweils gleich dimensioniert und äquidistant angeordnet worden sind.

Beim Beispiel nach Figur 2 war jedoch die Summe der Berührungsflächen an den oberen Stirnflächen der zylinderförmigen Erhebungen gegenüber dem Beispiel nach Figur 1 erhöht, so dass die Gesamtfläche dieses Halteelementes doppelt so groß, wie die Summe aller Berührungsflächen ist.

Mit dem erfindungsgemäßen elektrostatischen Halteelementen kann die jeweilige Größe der Berührungsflächen für die jeweilige Anwendung optimiert werden. Ein weiterer Parameter insbesondere für die jeweils erreichbaren elektrostatischen Haltekräfte ist außerdem die Tiefe von Vertiefungen h, über die die jeweiligen Anteile an den Haltekräften, die über das Coulombund das Johnson-Rahbek Verhalten aufgebracht werden können, beeinflussbar sind und über die auch festgelegt wird, welche Partikelgröße dort abgeschieden werden kann, ehe eine Deformation des aufliegenden Substrats oder Elementes erfolgt. Bei beiden, in den Figuren 1 und 2 gezeigten Beispielen, wurde herstellungsgemäß sichergestellt, dass alle Berührungsflächen mit einer Toleranz < 1 µm innerhalb einer gemeinsamen Ebene lagen und so eine hochebene Auflagefläche für ein Element oder Substrat auf einer Fläche von mindestens 150 mm × 150 mm bzw. über einen Durchmesser von 200 mm bildeten.

Es konnten Haltedrücke pro Flächeneinheit an Auflagefläche in Höhe von etwa 400 mbar bei einer angelegten Gleichspannung von 500 V und Dicke des dielektrischen Teils von etwa 0,2 mm des Halteelementes erreicht werden.

## Patentansprüche

1. Elektrostatisches Halteelement für bei der lithographischen Strukturierung von Halbleiterelementen zu fixierenden Elementen oder Substraten für Halbleiterelemente, das aus einem Werkstoff, der einen spezifischen elektrischen Widerstand bei einer Temperatur von 20 °C > 10¹³ Ωcm
und einen Wärmaausdehnungskoeffizienten, dessen absoluter Betrag mindestens im Temperaturbereich zwischen 0 und 50 °C < 10⁻⁷/K aufweist, besteht,
dabei der dielektrisch Teil des Halteelementes eine Dicke < 0,5 mm aufweist und die Oberfläche zum Halten des Elementes oder Substrates strukturiert ist,
**dadurch gekennzeichnet, dass**
der Werkstoff mit einem. Alkali/Erdalkali - Alumino - Silikat in einer SiO₂-Matrix gebildet ist.

2. Halteelement nach Anspruch 1,
**dadurch gekennzeichnet, dass** das Alkali/Erdalkali - Alumino - Silikat LiAlSiO₄, LiAl-Si₂O₆ oder Zn_{0,5}AlSi₂O₆ ist.

3. Halteelement nach mindestens einem der vorhergehenden Ansprüche, **dadurch gekennzeichnet, dass** die Strukturierung in Form von Erhebungen, deren abgeflachte Berührungsflächen in einer gemeinsamen Ebene angeordnet sind, ausgebildet ist, deren Lageabweichungen in Bezug zu dieser Ebene < 1 µm sind.

4. Halteelement nach Anspruch 3,
**dadurch gekennzeichnet, dass** die Erhebungen zylinderförmig, quaderförmig, in Form von Kegel- oder Pyramidenstümpfen ausgebildet sind.

5. Halteelement nach Anspruch 3 oder 4,
**dadurch gekennzeichnet, dass** zwischen den Erhebungen Vertiefungen ausgebildet sind, deren Tiefe < 0,5 mm und > 0,001 mm ist.

6. Halteelement nach mindestens einem der Ansprüche 1 bis 5, **dadurch gekennzeichnet, dass** die Strukturierung in Form von Vertiefungen oder Durchbrechungen ausgebildet ist.

7. Halteelement nach mindestens einem der vorhergehenden Ansprüche, **dadurch gekennzeichnet, dass** die Berührungsflächen für das Element oder Substrat eine mittlere Rauhtiefe Ra und/oder einem quadratischen Mittenrauhwert R_{q} < 1 µm aufweisen.

8. Halteelement nach mindestens einem der vorhergehenden Ansprüche, **dadurch gekennzeichnet, dass** die Strukturierung über die Fläche des Halteelementes gleichmäßig ausgebildet ist.

9. Halteelement nach mindestens einem der vorhergehenden Ansprüche, **dadurch gekennzeichnet, dass** die Erhebungen, Vertiefungen oder Durchbrechungen jeweils gleich dimensioniert und äquidistant angeordnet sind.

10. Halteelement nach mindestens einem der vorhergehenden Ansprüche, **dadurch gekennzeichnet, dass** das Verhältnis der Summe der Berührungsflächen in Bezug zur Gesamtfläche des Halteelementes zwischen 1 : 1,01 und 1 : 200 liegt.

11. Halteelement nach mindestens einem der vorhergehenden Ansprüche, **dadurch gekennzeichnet, dass** die Summe der Berührungsflächen innerhalb eines äußeren Randbereiches des Halteelementes mindestens zweimal so groß, wie in einem zentralen Innenbereich des Halteelementes ist.

12. Halteelement nach Anspruch 11,
**dadurch gekennzeichnet, dass** die Breite des äußeren Randbereiches ≤ einem viertel der Diagonalen oder des Durchmessers des Halteelementes ist:

13. Halteelement nach mindestens einem der vorhergehenden Ansprüche, **dadurch gekennzeichnet, dass** innerhalb eines zentralen Innenbereiches des Halteelementes mindestens eine Durchbrechung ausgebildet ist.

14. Halteelement nach mindestens einem der vorhergehenden Ansprüche, **dadurch gekennzeichnet, dass** an mindestens einer Durchbrechung eine einen Unterdruck erzeugende Einheit angeschlossen oder anschließbar ist.

15. Halteelement nach mindestens einem der vorhergehenden Ansprüche, **dadurch gekennzeichnet, dass** mindestens zwei orthogonal zueinander und orthogonal in Bezug zur Ebene der Berührungsfläche(n) ausgerichtete reflektierende Flächen für eine interferometrische Positionsbestimmung des Halteelementes am Halteelement vorhanden sind.

16. Halteelement nach Anspruch 15,
**dadurch gekennzeichnet, dass** die mittlere Rauhtiefe Rₐ und/oder der quadratische Mittenrauhwert R_{q} der reflektierenden Flächen < 0,05 µm ist.

17. Halteelement nach mindestens einem der vorhergehenden Ansprüche, **dadurch gekennzeichnet, dass** das mit dem Halteelement zu fixierende Element oder Substrat eine Maske oder ein Wafer ist.

## Claims

1. Electrostatic holding element for elements or substrates for semiconductor elements which are to be fixed during the lithographic patterning of semiconductor elements, the holding element being composed of a material having a specific electrical resistivity of greater than 10¹³ Ωcm at a temperature of 20°C
and a coefficient of thermal expansion with an absolute value of less than 10⁻⁷ /K, at least in the temperature range of between 0 and 50°C,
the dielectric part of the holding element having a thickness of less than 0.5 mm and the surface for holding the element or substrate being textured,
**characterised in that**
the material is formed with an alkali/alkaline-earth aluminosilicate in a SiO₂ matrix.

2. Holding element according to Claim 1,
**characterised in that** the alkali/alkaline-earth aluminosilicate is LiAlSiO₄, LiAlSi₂O₆ or Zn_{0,5}AlSi₂O₆.

3. Holding element according to at least one of the preceding claims, **characterised in that** the texturing takes the form of prominences, the flattened contact areas of which are arranged in a common plane, and the position deviations of which in relation to this plane are less than 1 µm.

4. Holding element according to Claim 3,
**characterised in that** the prominences are cylinder-shaped, cuboid-shaped, in the shape of truncated cones or truncated pyramids.

5. Holding element according to Claim 3 or 4, **characterised in that** indentations are formed between the prominences, the depth of these indentations being less than 0.5 mm and greater than 0.001 mm.

6. Holding element according to at least one of Claims 1 to 5, **characterised in that** the texturing takes the form of indentations or openings.

7. Holding element according to at least one of the preceding claims, **characterised in that** the contact areas for the element or substrate have a centreline average roughness Ra and/or a root mean square average roughness R_{q} of less than 1 µm.

8. Holding element according to at least one of the preceding claims, **characterised in that** the texturing is formed uniformly over the area of the holding element.

9. Holding element according to at least one of the preceding claims, **characterised in that** the prominences, indentations or openings are each identically dimensioned and equidistantly arranged.

10. Holding element according to at least one of the preceding claims, **characterised in that** the ratio of the sum of the contact areas in relation to the total area of the holding element is between 1:1.01 and 1:200.

11. Holding element according to at least one of the preceding claims, **characterised in that** the sum of the contact areas within an outer edge region of the holding element is at least twice as great as in a central inner region of the holding element.

12. Holding element according to Claim 11, **characterised in that** the width of the outer edge region is less than or equal to a quarter of the diagonal or diameter of the holding element.

13. Holding element according to at least one of the preceding claims, **characterised in that** at least one opening is formed within a central inner region of the holding element.

14. Holding element according to at least one of the preceding claims, **characterised in that** a unit producing a negative pressure is connected or connectable to at least one opening.

15. Holding element according to at least one of the preceding claims, **characterised in that** at least two reflective areas oriented orthogonally to one another and orthogonally in relation to the plane of the contact area(s) are present on the holding element for interferometric position determination of the holding element.

16. Holding element according to Claim 15, **characterised in that** the centreline average roughness Rₐ and/or the root mean square average roughness Rq of the reflective areas is less than 0.05 µm.

17. Holding element according to at least one of the preceding claims, **characterised in that** the element or substrate to be fixed by the holding element is a mask or a wafer.

## Revendications

1. Elément de maintien électrostatique pour des éléments à fixer lors de la structuration lithographique d'éléments semi-conducteurs ou des substrats pour éléments semi-conducteurs, qui est constitué d'un matériau présentant une résistance électrique spécifique à une température de 20 °C d'une valeur supérieure à 10¹³ Ωcm
et un coefficient de dilatation thermique, dont la valeur absolue est inférieure à10⁻⁷/K au moins dans la plage de températures entre 0 et 50°C,
la partie diélectrique de l'élément de maintien présentant en l'occurrence une épaisseur inférieure à 0,5 mm et la surface pour le maintien de l'élément ou du substrat étant structurée,
**caractérisé en ce que**
le matériau est formé d'un aluminosilicate de métal alcalin/alcalinoterreux dans une matrice de SiO₂.

2. Elément de maintien selon la revendication 1,
**caractérisé en ce que** l'aluminosilicate de métal alcalin/alcalinoterreux est le composé LiAlSiO₄, LiAlSi₂O₆ ou Zn_{0,5}AlSi₂O₆.

3. Elément de maintien selon au moins l'une quelconque des revendications précédentes, **caractérisé en ce que** la structuration se présente sous la forme de surélévations, dont les surfaces de contact aplaties sont agencées dans un plan commun, dont les écarts de couche par rapport à ce plan sont inférieurs à 1 µm.

4. Elément de maintien selon la revendication 3,
**caractérisé en ce que** les surélévations se présentent sous la forme de cylindres, de parallélépipèdes, de troncs de cône ou de troncs de pyramide.

5. Elément de maintien selon la revendication 3 ou 4,
**caractérisé en ce qu'**entre les surélévations, il apparaît des cavités dont la profondeur est inférieure à 0,5 mm et supérieure à 0,001 mm.

6. Elément de maintien selon au moins l'une quelconque des revendications 1 à 5, **caractérisé en ce que** la structuration se présente sous la forme de cavités ou de perçages.

7. Elément de maintien selon au moins l'une quelconque des revendications précédentes, **caractérisé en ce que** les surfaces de contact pour l'élément ou le substrat présentent une profondeur moyenne de rugosité Rₐ et/ou une moyenne quadratique de hauteur de rugosité R_{q} inférieure(s) à 1 µm.

8. Elément de maintien selon au moins l'une quelconque des revendications précédentes, **caractérisé en ce que** la structuration est réalisée uniformément sur la surface de l'élément de maintien.

9. Elément de maintien selon au moins l'une quelconque des revendications précédentes, **caractérisé en ce que** les surélévations, les cavités ou les perçages sont respectivement de mêmes dimensions et agencés de manière équidistante.

10. Elément de maintien selon au moins l'une quelconque des revendications précédentes, **caractérisé en ce que** le rapport de la somme des surfaces de contact à la surface totale de l'élément de maintien se situe entre 1:1,01 et 1:200.

11. Elément de maintien selon au moins l'une quelconque des revendications précédentes, **caractérisé en ce que** la somme des surfaces de contact dans une zone de bord externe de l'élément de maintien est au moins deux fois plus grande que dans une zone interne centrale de l'élément de maintien.

12. Elément de maintien selon la revendication 11,
**caractérisé en ce que** la largeur de la zone de bord externe est inférieure ou égale à un quart de la diagonale ou du diamètre de l'élément de maintien.

13. Elément de maintien selon au moins l'une quelconque des revendications précédentes, **caractérisé en ce qu'**au moins un perçage est réalisé dans une zone interne centrale de l'élément de maintien.

14. Elément de maintien selon au moins l'une quelconque des revendications précédentes, **caractérisé en ce qu'**une unité générant une dépression est raccordée ou peut être raccordée à au moins un perçage.

15. Elément de maintien selon au moins l'une quelconque des revendications précédentes, **caractérisé en ce qu'**au moins deux surfaces réfléchissantes orientées orthogonalement l'une à l'autre et orthogonalement au plan de la ou des surfaces de contact sont présentes sur l'élément de maintien pour une détermination de position interférométrique de l'élément de maintien.

16. Elément de maintien selon la revendication 15,
**caractérisé en ce que** la profondeur moyenne de rugosité Rₐ et/ou la moyenne quadratique de hauteur de rugosité R_{q} des surfaces réfléchissantes est/sont inférieure(s) à 0,05 µm.

17. Elément de maintien selon au moins l'une quelconque des revendications précédentes, **caractérisé en ce que** l'élément ou le substrat à fixer avec l'élément de maintien est un masque ou une tranche.
